Europäisches Patentamt

European Patent Office

Office européen des brevets

(11) Veröffentlichungsnummer: **0 305 734**
**A2**

(12) # EUROPÄISCHE PATENTANMELDUNG

(21) Anmeldenummer: **88112164.4**

(51) Int. Cl.⁴: **G01R 1/073**

(22) Anmeldetag: **27.07.88**

(30) Priorität: **26.08.87 DE 8711580 U**

(43) Veröffentlichungstag der Anmeldung:
**08.03.89 Patentblatt 89/10**

(84) Benannte Vertragsstaaten:
**BE DE ES FR GB IT NL**

(71) Anmelder: **Siemens Aktiengesellschaft Berlin und München**
**Wittelsbacherplatz 2**
**D-8000 München 2(DE)**

(72) Erfinder: **Prang, Hans-Joachim, Dipl.-Ing.**
**Langgasserweg 12**
**D-6742 Herxheim(DE)**
Erfinder: **Wahl, Karl-August**
**Forlen 19**
**D-7516 Karlsbad(DE)**

(54) **Prüfanordnung für Leiterplatten.**

(57) Bei einer Prüfanordnung für Leiterplatten mit Kontaktnadeln zur Kontaktierung der zu prüfenden Leiterbahnen, einer Rangierleiterplatte zwischen den Kontaktnadeln und einer Nadelträgerplatte sowie einem Kontaktflächenfeld, auf das die Nadeln der Nadelträgerplatte aufsetzen und mit dem eine Verbindung zu den elektronischen Auswerteeinheiten des Prüfsystems herstellbar ist, werden zur Reduzierung der Anschlußpunktezahl im Kontaktflächenfeld Zonen gleicher Kontaktpunktzahl gebildet.

Die Erfindung ist vor allem bei Prüfanordnungen für Leiterplatten in der Fertigung für elektronische Geräte anwendbar.

FIG 1

EP 0 305 734 A2

## Prüfanordnung für Leiterplatten

### Technisches Gebiet

Die Erfindung betrifft eine Prüfanordnung für Leiterplatten mit Kontaktnadeln zur Kontaktierung der zu prüfenden Leiterbahnen, welche in einem Zwischenadapter eingesetzt sind, einer Rangierleiterplatte zwischen den Kontaktnadeln und einer Nadelträgerplatte, mit der die dem Prüfling abgewandten Kontaktpunkte der Kontaktnadeln auf ein vorgegebenes Raster umrangiert werden, und mit einem Kontaktflächenfeld mit Kontaktpunkten im vorgegebenen Raster, auf das die Nadeln der Nadelträgerplatte aufsetzen und mit dem eine Verbindung zu den elektronischen Auswerteeinheiten der Prüfanordnung herstellbar ist.

### Stand der Technik

Eine solche Prüfanordnung ist aus der DE-OS 29 54 194 bekannt. Die Prüfanordnung wird im Leiterplattenprüfautomat eingesetzt, um das senkrechte Kontaktieren mit Prüfnadeln auf den rasterfrei angeordneten Prüfflächen der Prüflinge zu ermöglichen. Ein solcher Universalprüfadapter bietet Kontaktpunkte in Form von Nadeln oder Flächen in einem bestimmten Raster (z. B. 1/10") an. Ausgehend von diesem festen Raster werden über eine Leiterplatte die Kontakte so rangiert, daß sie zu den Prüfflächen des Prüflings spiegelbildlich angeordnet sind. Eine senkrechte Nadelkontaktierung ist somit möglich, insbesondere auch die Umsetzung von einer 1/10"- auf 1/20"-Rasteranordnungen.

Häufig ist es notwendig, beispielsweise eine engere Kontaktanordnung wie 1/20" innerhalb eines normalen 1/10"-Rasters zu adaptieren, wobei allerdings eine vollständige engere Anordnung, wie z. B. 1/20", einen zu großen Aufwand darstellt bzw. aus mechanischen Gründen nicht herstellbar ist.

### Darstellung der Erfindung

Der Erfindung liegt die Aufgabe zugrunde, eine Prüfanordnung für Leiterplatten zu schaffen, die eine große Flexibilität hinsichtlich des Prüfrasters bei relativ geringem Aufwand gewährleistet.

Zur Lösung dieser Aufgabe ist bei einer Prüfanordnung zur Reduzierung der Anschlußpunktezahl bei der Anschaltung der Auswerteeinheiten das Kontaktflächenfeld in Zonen mit jeweils gleicher Kontaktpunktzahl eingeteilt, wobei jeder Kontaktpunkt einer Zone mit je einem Kontaktpunkt der weiteren Zone verbunden und auf einen Stecker am Rande des Kontaktflächenfeldes geführt ist.

Gemäß der Erfindung ist es möglich, Adapter für unbestückte und bestückte Leiterplatten aufzubauen, die auch in größeren Dimensionen (z. B. größer 30.000 Testpunkte) noch wirtschaftlich herstellbar sind. Die elektrische Verbindung der Durchschaltemeßelektronik auf ein Kontaktfeld (Adapterfeld) größerer Dimension erfordert einen hohen Entwicklungs- und Fertigungsaufwand hinsichtlich der Kabelzuführung, der Kabelabfangung und des Platzbedarfs für Stecker und Kabel. Auch die Herstellung des Kontaktfeldes sowie die Reparatur und Wartung ist bei ausreichender Zugänglichkeit sichergestellt.

Die in den Unteransprüchen beschriebenen Ausführungsbeispiele gewährleisten eine vorteilhafte Verteilung der Kontaktpunkte, wenn das gesamte Feld z. B. im 1/20"-Raster aufgebaut ist, so daß das Kontaktfeld mit zwei verschiedenen Grundrastern betrieben werden kann, erstens über der inneren Fläche als 1/20"-Kontaktfeld, zweitens über die gesamte Fläche als 1/10"-Kontaktfeld sowie drittens über eine Rangierleiterplatte, mit der eine beliebig gemischte Kontaktrasterung für den Prüfling auf der gesamten Fläche erzeugt werden kann, ohne Veränderungen an der Verkabelung zur Auswerteelektronik vorzunehmen.

### Kurze Beschreibung der Zeichnung

Die Erfindung wird anhand der Figuren erläutert, wobei

Figur 1 eine Gesamtdarstellung eines Leiterplattenprüfautomaten,

Figur 2 eine Schemadarstellung der Zonen eines Kontaktfeldes für einen Leiterplattenprüfautomat und

Figur 3 ein Ausführungsbeispiel für eine Verbindung von Kontaktpunkten des Kontaktflächenfeldes darstellt.

Bester Weg zur Ausführung der Erfindung

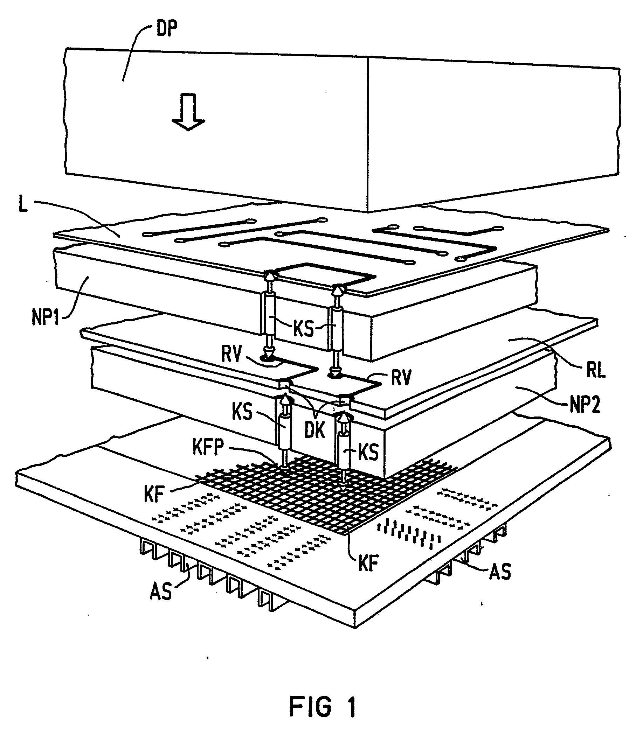

In der Figur 1 ist ein Leiterplattenprüfautomat gezeigt, bei dem zwischen einer Druckplatte DP und einer Nadelträgerplatte NP1 mit Kontaktstiften KS die zu prüfende Leiterplatte L liegt. Über eine Rangierleiterplatte RL mit Rangierverbindungen RV und Durchkontaktierungen DK und eine Nadelträgerplatte NP2 mit Kontaktstiften KS werden Prüfverbindungen zu einem Kontaktfeld KF hergestellt, bei dem von in einem Raster (z. B. 1/10") liegenden Kontaktfeldpunkten KFP über Anschlüsse AS die nicht dargestellte Auswerteelektronik angeschlossen wird.

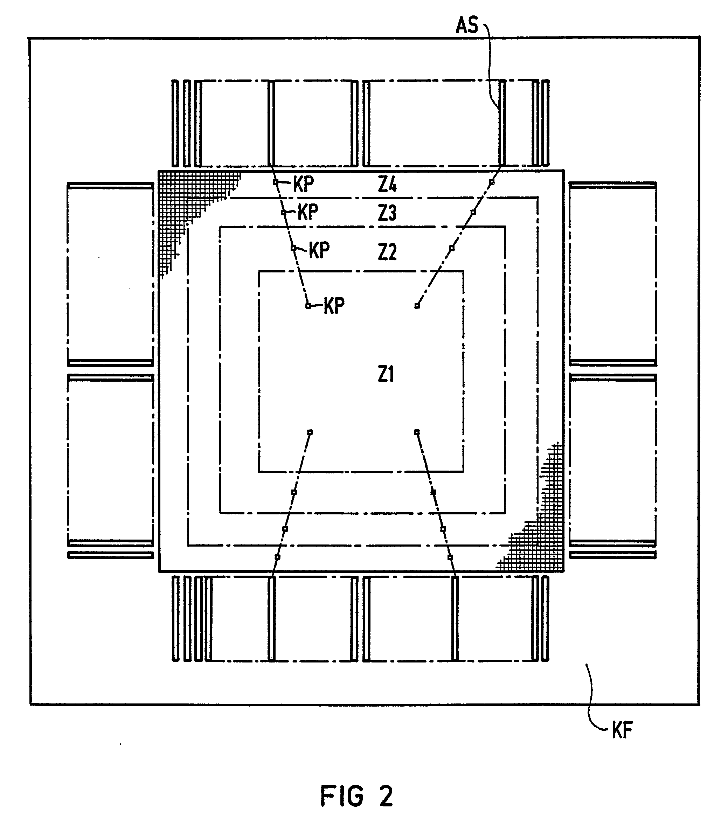

Das Kontaktfeld KF wird beim dargestellten Beispiel nach der Figur 2 in vier Zonen Z1 bis Z4 mit jeweils gleicher Kontaktpunktzahl eingeteilt. Jeder Kontaktpunkt KP der Zone Z1 wird mit je einem Kontaktpunkt KP der Zone Z2, Z3 und Z4 verbunden und anschließend auf einen Anschluß AS, beispielsweise einen Stekkerpin, am Rande des Kontaktfeldes KF geführt. Bei dieser Anordnung ergibt sich hieraus ein Verhältnis von 4 : 1 Kontaktpunkten zu elektronischen Durchschaltemeßpunkten der hier nicht dargestellten Auswerteelektronik, d. h., pro elektronischen Durchschaltemeßpunkt werden vier Kontaktpunkte KP im Kontaktfeld KF des Leiterplattenprüfautomaten angeboten.

Die Kontaktpunkte der Zone Z1 werden zu 100 % mit elektronischen Durchschaltemeßpunkten versorgt.

$$Z1 \rightarrow 100\ \%$$
$$Z1 + Z2 \rightarrow Versorgungsgrad\ 50\ \%$$
$$Z1 + Z2 + Z3 \rightarrow Versorgungsgrad\ 30\ \%$$
$$Z1 + Z2 + Z3 + Z4 \rightarrow Versorgungsgrad\ 25\ \%$$

wobei Z4 nur noch einen schmalen äußeren Rahmen im Kontaktfeld KF bildet.

Die Kontaktpunkte der Zonen Z1 bis Z4 können beispielsweise so miteinander verbunden werden, daß sich eine Verteilung im Raster 2/10" = 1/5" von 100 % über das gesamte Feld ergibt, wenn das "Grundraster" 1/10" beträgt.

Die Kontaktpunktverbindungen des Kontaktfeldes KF werden beispielsweise im Entflechtungssystem (CAD/CAT) für die Herstellung der zu prüfenden Leiterplatte abgelegt und können den Prüfpunkten dieses Prüflings überlagert werden, d. h., das Entflechtungssystem kann erkennen, ob zwei bzw. drei miteinander verbundene Kontaktpunkte des Kontaktfeldes mit den Prüfpunkten des Prüflings kollidieren. Es wird eine Kollisionspunkteliste erstellt, welche im nächsten Schritt zur Generierung der Rangierleiterplatte RL benötigt wird, d. h., die ungenutzten, benachbarten Kontaktpunkte KP des Kontaktfeldes KF werden auf die Kollisionspunkte rangiert.

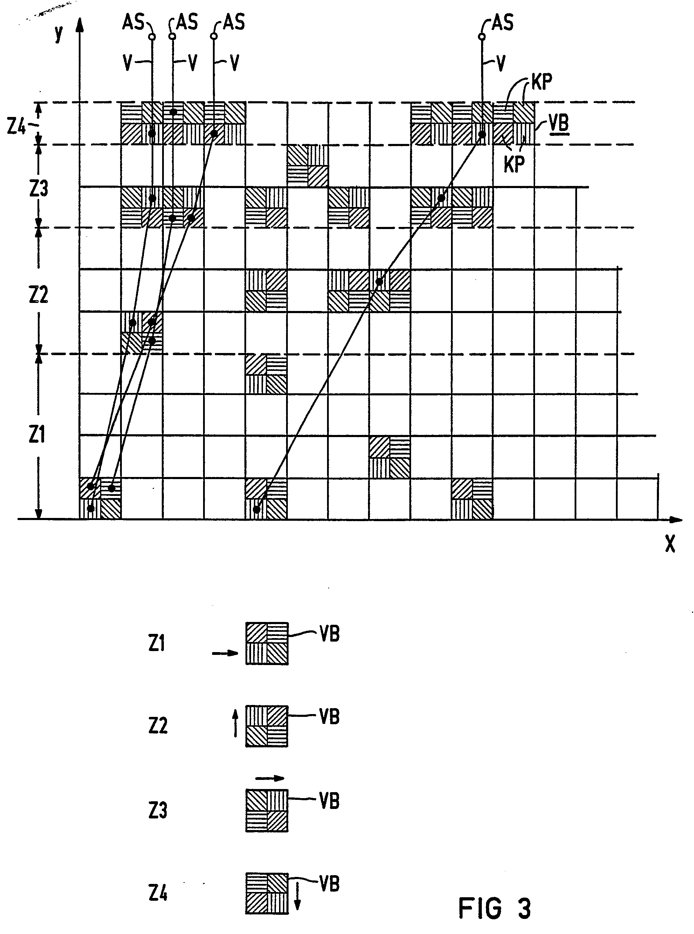

In der Figur 3 sind im oberen Teil ausschnittsweise Teile der Zonen Z1 bis Z4 mit jeweils Viererblöcken VB von Kontaktpunkten KP dargestellt. Eine nächstgrößere Rasterung wird mit Verbindungsleitungen zwischen einzelnen Kontaktpunkten KP hergestellt; diese verknüpfen jeweils vier Kontaktpunkte KP aus verschiedenen Zonen Z1 bis Z4 mit einem Anschluß AS. Im unteren Teil der Figur 3 ist schematisch der Ort der miteinander verbundenen Kontaktpunkte KP innerhalb der jeweiligen Viererblöcke VB gezeigt. Es ist hieraus erkennbar, daß sich ein Umlauf der Orte der untereinander verbundenen Kontaktpunkte KP von der Zone Z1 bis Z4 innerhalb der Viererblöcke VB ergibt.

Gewerbliche Anwendbarkeit

Die Erfindung ist vor allem bei Prüfanordnungen für Leiterplatten in der Fertigung für elektronische Geräte anwendbar.

**Ansprüche**

1. Prüfanordnung für Leiterplatten mit
- Kontaktnadeln zur Kontaktierung der zu prüfenden Leiterbahnen, welche in einem Zwischenadapter eingesetzt sind,
- einer Rangierleiterplatte zwischen den Kontaktnadeln und einer Nadelträgerplatte, mit der die dem Prüfling abgewandten Kontaktpunkte der Kontaktnadeln auf ein vorgegebenes Raster umrangiert werden, und mit

- einem Kontaktflächenfeld mit Kontaktpunkten im vorgegebenen Raster, auf das die Nadeln der Nadelträgerplatte aufsetzen und mit dem eine Verbindung zu den elektronischen Auswerteeinheiten der Prüfanordnung herstellbar ist,

**dadurch gekennzeichnet, daß**

- zur Reduzierung der Anschlußpunktezahl bei der Anschaltung der Auswerteeinheiten das Kontaktflächenfeld in Zonen (Z1, Z2, Z3, Z4) mit jeweils gleicher Kontaktpunktzahl eingeteilt ist, wobei
- jeder Kontaktpunkt einer Zone (Z1) mit je einem Kontaktpunkt der weiteren Zone (Z2, Z3, Z4) verbunden und auf einen Stecker am Rande des Kontaktflächenfeldes geführt ist.

2. Prüfanordnung nach Anspruch 1, **dadurch gekennzeichnet, daß**

- bei einer Reduzierung der Anschlußpunktezahl mittels Halbierung des Kontaktpunktabstands (1/10", 1/20") vier Zonen vorhanden sind, wobei, ausgehend von einer inneren Zone (Z1), die äußere Zone die jeweils innere Zone umschließt, und daß
- jeweils ein Kontaktpunkt eines Viererblocks (VB) der inneren Zone (Z1) mit dem Kontaktpunkt eines in Richtung auf die äußeren Anschlüsse des Kontaktflächenfeldes am nächsten liegenden Viererblocks (VB) in der jeweils äußeren Zone (Z2, Z3, Z4) fortlaufend verbunden ist.

3. Prüfanordnung nach Anspruch 2, **dadurch gekennzeichnet, daß**

- die jeweils miteinander verbundenen Kontaktpunkte der Viererblöcke (VB) an verschiedenen Orten innerhalb der Viererblöcke (VB) liegen, derart, daß sich von der inneren Zone (Z1) zur äußeren Zone (Z4) ein Umlauf innerhalb der Anordnung im jeweiligen Viererblock ergibt.

87 P 4454 E

FIG 1

FIG 2

87 P 4454 E

FIG 3